# EUROPEAN PATENT APPLICATION

(11) **EP 3 343 637 A1**
(43) Date of publication of application: **04.07.2018**
(21) Application number: 17208753.8
(22) Date of filing: 20.12.2017
(51) Int. Cl.: H01L 29/739, H01L 29/423, H01L 29/49, H01L 29/78, H01L 27/088

(54) **SEMICONDUCTOR DEVICE AND POWER CONVERTER**

(30) Priority: 27.12.2016 JP 2016253709
(71) Applicant: Renesas Electronics Corporation, Tokyo 135-0061 (JP)
(72) Inventor: Ojima, Yusuke, Tokyo 135-0061 (JP); Yokoi, Yoshihiko, Tokyo 135-0061 (JP)
(74) Representative: Betten & Resch

(57) **Abstract**

To provide a semiconductor device capable of preventing a surge voltage at the time of turn-off without complicating a gate drive circuit and without increasing switching delay.

A semiconductor device has a configuration in which a plurality of transistors are equivalently coupled in parallel by including a plurality of control electrodes for controlling a current flowing between a first main electrode and a second main electrode. A resistance value of a transmission path of a control signal from a common control terminal varies with respect to each of the control electrodes.

## Description

### CROSS-REFERENCE TO RELATED APPLICATIONS

The disclosure of Japanese Patent Application No. 2016-253709 filed on December 27, 2016 including the specification, drawings and abstract is incorporated herein by reference in its entirety.

### BACKGROUND

The present invention relates to a semiconductor device, which is preferably used as a switching element for a power converter, for example.

In a semiconductor switching element used for a power converter, a bidirectional switch, or the like, it is important to suppress a surge voltage during turn-off without increasing a switching delay.

For example, Japanese Unexamined Patent Application Publication No. HEI10 (1998) -075164 discloses a configuration of a semiconductor switching device in which a gate drive circuit is doubled. As for the turn-off, the first gate drive circuit operates from the beginning of the turn-off, and the second gate drive circuit operates after a predetermined time.

Japanese Unexamined Patent Application Publication No. HEI10 (1998)-075164 described above also discloses a configuration in which a circuit dedicated to beginning of turn-off is additionally provided to the gate drive circuit, as another embodiment. The circuit dedicated to beginning of turn-off includes a discharge path between a common terminal of the switching circuit and a ground level.

### SUMMARY

The configuration disclosed in Japanese Unexamined Patent Application Publication No. HEI10 (1998)-075164 above involves a problem that the configuration of the gate drive circuit is complicated because two circuits are provided for the turn-off. Other problems and novel features will be apparent from description of this application and accompanying drawings.

In a semiconductor device according to one embodiment, a control electrode for controlling a main current flowing through a first main electrode and a second main electrode is divided into a plurality of pieces. The resistance value of a transmission path of a control signal from a common control terminal is different from each of the divided control electrode to another.

According to the above embodiment, it is possible to provide a semiconductor device capable of controlling a surge voltage at the time of turn-off without complicating a gate drive circuit and without increasing switching delay.

### BRIEF DESCRIPTION OF THE DRAWINGS

Fig. 1 is an equivalent circuit showing a configuration of a semiconductor device according to a first embodiment;
Fig. 2 is an equivalent circuit of a variation shown in Fig. 1;
Fig. 3 is a timing chart showing operation of the semiconductor device shown in Fig. 1;
Fig. 4 is a plan view showing an example of a structure of the semiconductor device corresponding to the equivalent circuit shown in Fig. 1;
Fig. 5 is a sectional view taken along a section line V-V shown in Fig. 4;
Fig. 6 is a sectional view taken along a section line VI-VI shown in Fig. 4;
Fig. 7 is a flowchart showing an example of a method of manufacturing the semiconductor device shown in Figs. 4 to 6;
Fig. 8 is an equivalent circuit showing a configuration of a semiconductor device according to a second embodiment;
Fig. 9 is a plan view showing an example of a structure of the semiconductor device corresponding to the equivalent circuit shown in Fig. 8;
Fig. 10 is a sectional view taken along a section line X-X shown in Fig. 9;
Fig. 11 is a sectional view taken along a section line XI-XI shown in Fig. 9;
Fig. 12 is a circuit diagram showing an example of a bidirectional switch used in a rechargeable battery pack; and
Fig. 13 is a circuit diagram showing a configuration of an inverter device.

### DETAILED DESCRIPTION

Hereinbelow, embodiments of the present invention will be described with reference to drawings. It should be noted that like or corresponding components are denoted by like numerals and the explanation thereof may not be repeated.

### First Embodiment

### [General Configuration of Semiconductor Device]

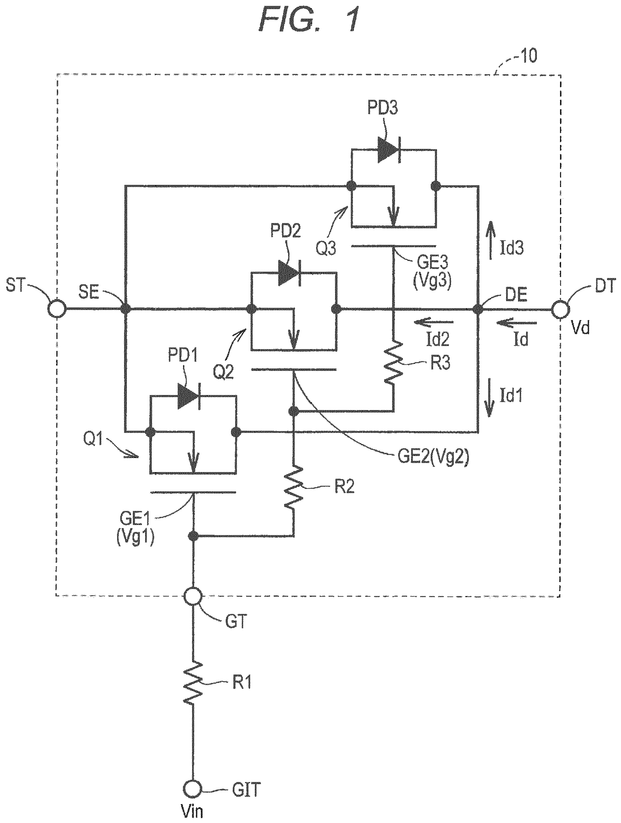

Fig. 1 is an equivalent circuit showing a configuration of a semiconductor device according to a first embodiment. With reference to Fig. 1, a semiconductor device 10 is a modified N-channel MOSFET (Metal Oxide Semiconductor Field Effect Transistor). The MOSFET is also described as "MOS transistor" hereinbelow.

The semiconductor device 10 includes a drain electrode DE as a first main electrode, a source electrode SE as a second main electrode, gate electrode portions GE1, GE2, GE3 as a plurality of control electrode portions, and resistive elements R2, R3. It should be noted that the collective gate electrode portions GE1, GE2, GE3 or unspecified one of them may be referred to simply as "gate electrode portion GE" hereinbelow.

Equivalently, the semiconductor device 10 can be considered as three N-channel MOS transistors Q1, Q2, Q3 coupled in parallel. The MOS transistors Q1, Q2, Q3 share both the drain electrode DE and the source electrode SE. On-off of the MOS transistors Q1, Q2, Q3 is controlled by a gate control signal supplied by each gate electrode portion GE of the MOS transistors Q1, Q2, Q3. Hereinbelow, the collective MOS transistors Q1, Q2, Q3 or any one of them may be referred to simply as "MOS transistor Q".

A drain current Id as a main current flows between the drain electrode DE and the source electrode SE. Equivalently, the drain current Id is divided into a plurality of drain current components Id1, Id2, Id3 corresponding to a plurality of gate electrode portions GE1, GE2, GE3. Each of the drain current components Id1, Id2, Id3 is controlled according to the gate control signal supplied to each gate electrode portion GE. In practice, the current component flowing through a channel near each gate electrode portion GE is controlled by the corresponding gate electrode portion GE.

Fig. 1 also shows diodes PD1, PD2, PD3 for commutation coupled to the MOS transistors Q1, Q2, Q3 in reverse-parallel (in reverse-bias direction and in parallel). The diodes PD1, PD2, PD3 may be parasitic diodes when the semiconductor device 10 is configured by a vertical MOS transistor, or may be diodes formed independently of the MOS transistors Q1, Q2, Q3.

The semiconductor device 10 includes a drain terminal DT, a source terminal ST, and a gate terminal GT to be coupled to the outside. The drain electrode DE is coupled to the drain terminal DT, and the source electrode SE is coupled to source terminal ST. As the main current, the drain current Id flows from the drain terminal DT to the source terminal ST.

The gate terminal GT is input with the gate control signal to control the drain current Id. Typically, a resistive element R1 is coupled between a gate signal input terminal GIT external to the semiconductor device 10 and the gate terminal GT. The resistive element R1 is mounted on a print circuit board along with the semiconductor device 10. By adjusting the resistance value of the resistive element R1, the size of the surge voltage and the switching speed can be adjusted ex-post facto.

The gate electrode portion GE1 is coupled directly to the gate terminal GT without either one of the resistive elements R2 and R3. The gate electrode portion GE2 is coupled to the gate electrode portion GE1 via the resistive element R2. The gate electrode portion GE3 is coupled to the gate electrode portion GE2 via the resistive element R3. The resistance value between the gate terminal GT and the gate electrode portion GE1 is smaller than the resistance value of the resistive element R2 or R3. Thus, the resistance value of the control signal path between each of the gate electrode portions GE1, GE2, GE3 and the gate terminal GT varies with respect to each gate electrode portion GE. In the case of Fig. 1, the gate resistance increases in the order of the gate electrode portions GE1, GE2, GE3.

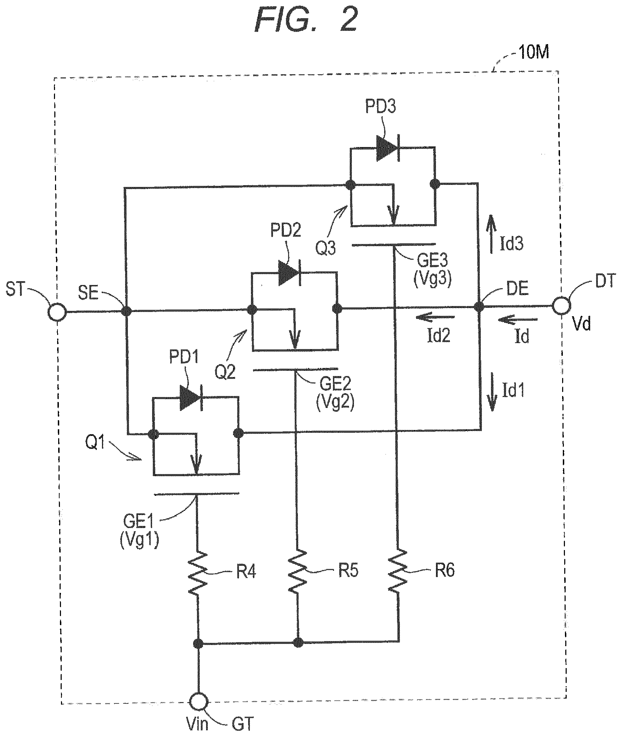

Fig. 2 is an equivalent circuit of a variation shown in Fig. 1. A semiconductor device 10M shown in Fig. 2 is different from the semiconductor device 10 shown in Fig. 1 in that resistive elements R4, R5, R6 are provided instead of the resistive elements R2, R3 in Fig. 1. With reference to Fig. 2, the gate electrode portion GE1 is coupled to the gate terminal GT via the resistive element R4. The gate electrode portion GE2 is coupled to the gate terminal GT via the resistive element R5. The gate electrode portion GE3 is coupled to the gate terminal GT via the resistive element R6.

It is assumed here that the resistance value of the resistive element R6 is larger than that of the resistive element R5 and that the resistance value of the resistive element R5 is larger than that of the resistive element R4. Thus, the resistance value of the control signal path between each of the gate electrode portions GE1, GE2, GE3 and the gate terminal GT varies with respect to each gate electrode and the relation among these resistance values is the same as that in the case of Fig. 1. However, an area occupied by the resistive element is larger in the case of Fig. 2. That is, the configuration shown in Fig. 1 is advantageous in that the area required for the resistive element can be reduced.

Because other features in Fig. 2 are the same as those in Fig. 1, like or corresponding components are denoted by like numerals and the explanation thereof is not repeated.

### [Operation of Semiconductor Device]

An operation of the semiconductor device 10 shown in Fig. 1 at the time of turn-off is described below. First, problems of the related-art semiconductor switching element encountered at the time of turn-off are described.

In general, for inductance L present in wiring or the like of the semiconductor circuit, a surge voltage L· (di/dt) is generated at the time of turn-off of the semiconductor switching element according to a change rate di/dt of a current i transitionally flowing through the semiconductor switching element. The surge voltage can cause a failure of the semiconductor circuit. Although the surge voltage can be adequately suppressed by coupling a relatively high gate resistance to the gate electrode, this high gate resistance can cause a significant delay to switching of the semiconductor switching element. As described below, the semiconductor device 10 according to this embodiment can suppress the surge voltage and also suppress an increase of a delay amount.

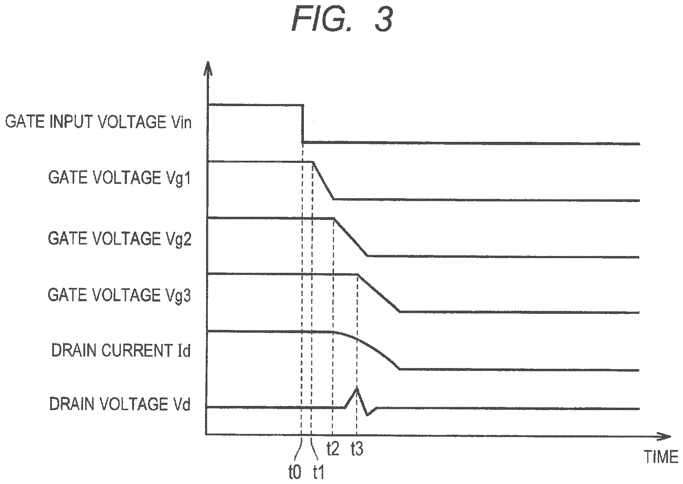

Fig. 3 is a timing chart showing operation of the semiconductor device shown in Fig. 1. Fig. 3 shows, from the top toward the bottom, a gate input voltage Vin at the gate signal input terminal GIT, gate voltages Vg1, Vg2, Vg3 at the gate electrode portions GE1, GE2, GE3, a drain current Id, and a drain voltage Vd.

With reference to Figs. 1 and 3, the gate input voltage Vin changes from a high level to a low level as the gate control signal at a time t0. The gate control signal reaches the gate electrode portion GE1 via the resistive element R1, reaches the gate electrode portion GE2 via the resistive elements R1, R2, and reaches the gate electrode portion GE3 via the resistive elements R1, R2, R3. The drain current components Id1, Id2, Id3 respectively flowing through the MOS transistors Q1, Q2, Q3 in the equivalent circuit shown in Fig. 1 are the whole drain current Id divided, which are smaller than the whole drain current Id.

Furthermore, because the delay amounts of the signals can be different by varying the values of the gate resistance of MOS transistors Q1, Q2, Q3 from one another, the timings at which the gate voltages Vg1, Vg2, Vg3 change are offset. Specifically in the case shown in Fig. 3, the MOS transistor Q1 having the lowest gate resistance starts breaking at a time t1. The MOS transistor Q2 having the second lowest gate resistance starts breaking at a subsequent time t2. The MOS transistor Q3 having the highest gate resistance starts breaking at a subsequent time t3.

As described above, the semiconductor device according to this embodiment equivalently has a configuration in which a plurality of MOS transistors Q are coupled in parallel by dividing the gate electrode into a plurality of pieces. This can reduce the drain current component flowing through each MOSFET because the current component generated by dividing the drain current Id flows through each MOS transistor Q. Furthermore, by varying the size of the gate resistance in each gate electrode portion GE, the timing offsets at which each MOS transistor Q breaks. Thus, the change rate di/dt of the current i can be reduced even if the breaking speed is increased, thereby suppressing the peak voltage of the surge. Moreover, because the size of the gate resistance in each gate electrode portion GE can be smaller than that of a single gate resistance as in the related art, a gate-charge discharging time until a gate voltage Vg of each MOS transistor Q drops to a threshold voltage can be reduced. As a result, the breaking time can be reduced in the entire semiconductor device 10.

### [Specific Structure of Semiconductor Device]

Hereinbelow, description is given taking an example of employing a trench gate MOSFET having a vertical structure as the semiconductor device 10. Using the vertical MOSFET can achieve the semiconductor device 10 configured as shown in Fig. 1 almost without changing the related-art structure.

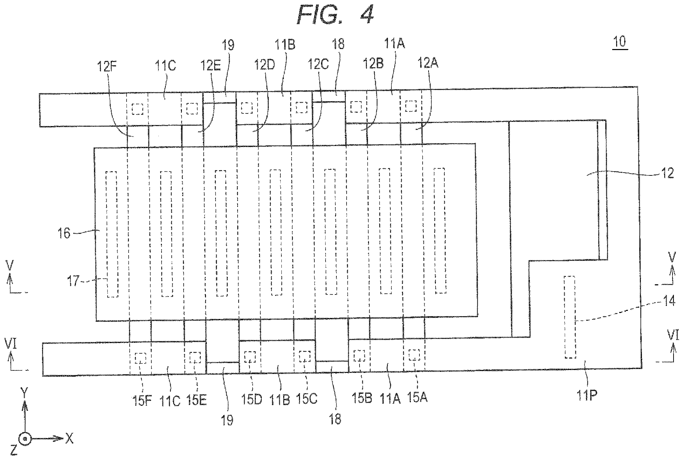

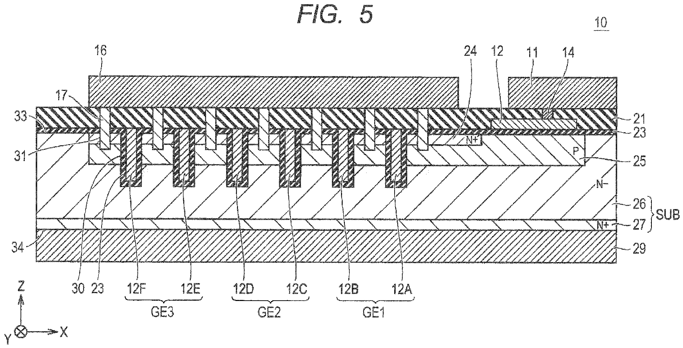

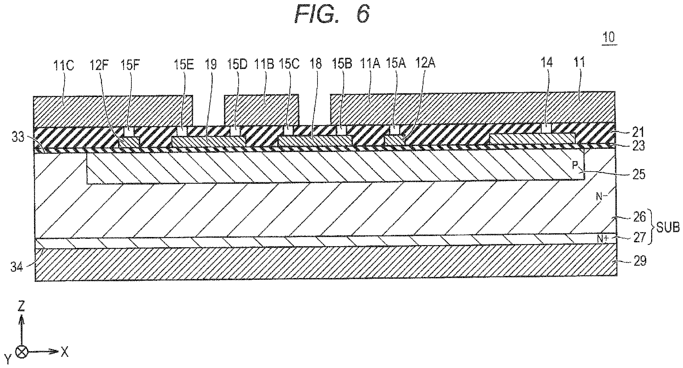

Fig. 4 is a plan view showing an example of a structure of the semiconductor device corresponding to the equivalent circuit shown in Fig. 1. Fig. 5 is a sectional view taken along a section line V-V shown in Fig. 4. Fig. 6 is a sectional view taken along a section line VI-VI shown in Fig. 4. In the following description, directions parallel to a semiconductor substrate SUB are regarded as an X direction and a Y direction, and a direction perpendicular to the semiconductor substrate SUB is regarded as a Z direction. It should be noted that an interlayer insulating layer 21 and a gate insulating film 23 are not shown in Fig. 4. It is also noted that the dimensions of portions shown in Figs. 4 to 6 are not proportional to the actual dimensions for better understanding.

With reference to Figs. 4 to 6, the semiconductor device 10 is formed mainly based on an N type semiconductor substrate SUB. The N type semiconductor substrate SUB has a two-layered structure including an N+ type semiconductor layer used as an N+ type drain layer 27 and an N- type semiconductor layer used as an N- type drift layer 26. In the following description, a surface of the N type semiconductor substrate SUB on the side of the +Z direction is referred to as a first main surface 33 or a front surface (front face), and a surface on the side of the -Z direction is referred to as a second main surface 34 or a rear surface. The N+ type semiconductor layer is on the side of the second main surface 34 and the N- type semiconductor layer is on the side of the first main surface 33.

As shown in Fig. 5, the semiconductor device 10 includes an N+ type source layer 24 and a P type base layer 25 from the closer side to the first main surface 33 of the N type semiconductor substrate SUB as impurities formed over the N- type drift layer 26. It should be noted that a periphery of the P type base layer 25 is not coated by the N+ type source layer 24. Formed over the periphery of this P type base layer 25 is a peripheral gate electrode 12 via the gate insulating film 23.

The semiconductor device 10 is formed with a plurality of trenches (grooves) 30 starting from the first main surface 33 through the N+ type source layer 24 and the P type base layer 25 to the internal of the N- type drift layer 26. As the semiconductor substrate SUB is seen from the above, the trenches 30 extend in the Y direction and are arrayed along the X direction. The gate insulating film 23 is formed all over the first main surface 33 of the semiconductor substrate SUB including the internal surface of each trench 30. Trench gate electrodes 12A to 12F that are filled gate electrodes are also formed inside each trench 30 via the gate insulating film 23. The gate electrodes 12A to 12F extend in the Y direction.

The trench gate electrodes 12A and 12B correspond to the gate electrode portion GE1 shown in Fig. 1, and are electrically coupled to each other via a gate wiring 11A to be described later. Similarly, the trench gate electrodes 12C and 12D correspond to the gate electrode portion GE2 shown in Fig. 1, and are electrically coupled to each other via a gate wiring 11B to be described later. The trench gate electrodes 12E and 12F correspond to the gate electrode portion GE3 shown in Fig. 1, and are electrically coupled to each other via a gate wiring 11C to be described later.

In this manner, each gate electrode portion GE is configured by a plurality of electrode elements electrically coupled to one another. Each electrode element corresponds to each of the trench gate electrodes 12A to 12F. A resistance value between the electrode elements is smaller than that of any one of the resistive element R2, R3 shown in Fig. 1.

The semiconductor device 10 further includes the aforementioned peripheral gate electrode 12, the interlayer insulating layer 21, and resistive layers 18 and 19.

The resistive layer 18 is formed by, for example, polysilicon so as to couple an end portion of the gate electrode 12B and an end portion of the gate electrode 12C. The resistive layer 19 is formed by, for example, polysilicon so as to couple an end portion of the gate electrode 12D and an end portion of the gate electrode 12E. The resistive layer 18 corresponds to the resistive element R2 shown in Fig. 1, and the resistive layer 19 corresponds to the resistive element R3 shown in Fig. 1.

The interlayer insulating layer 21 is formed over the gate insulating film 23 so as to cover the gate electrodes 12A to 12F, the resistive layer 18 and 19, and the peripheral gate electrode 12.

The semiconductor device 10 further includes a metal source electrode 16, a metal drain electrode 29, the gate wirings 11A, 11B, 11C, and a gate pad 11P. The gate wiring 11A and the gate pad 11P are formed integrally. It should be noted that the collective gate wirings 11A, 11B, 11C or unspecified one of them may be referred to simply as "gate wiring 11" hereinbelow.

The metal source electrode 16 is formed over the interlayer insulating layer 21, and coupled to the N+ type source layer 24 and the P type base layer 25 via a plurality of contact electrodes 17. These contract electrodes 17 are arranged between adjacent trenches 30 and outside the trench 30 arranged outermost. Each contact electrode 17 penetrates the interlayer insulating layer 21, the gate insulating film 23, and the N+ type source layer 24 to reach the internal of the P type base layer 25. The metal source electrode 16 corresponds to the source electrode SE shown in Fig. 1.

The metal drain electrode 29 is formed abutting the N+ type drain layer 27 on the rear surface side of the semiconductor substrate SUB. The metal drain electrode 29 corresponds to the drain electrode DE shown in Fig. 1.

The gate wiring 11A extends generally in the X direction and is coupled via end portions of the gate electrodes 12A and 12B and contact electrodes 15A and 15B, respectively. The gate wiring 11A is formed integrally with the gate pad 11P. The gate pad 11P is further coupled to the peripheral gate electrode 12 via a contact electrode 14.

The gate wiring 11B extends in the X direction and is coupled via end portions of the gate electrodes 12C and 12D and contact electrodes 15C and 15D, respectively. The gate wiring 11C extends in the X direction and is coupled via end portions of the gate electrodes 12E and 12F and contact electrodes 15E and 15F, respectively. Thus, the gate wiring 11A and the gate wiring 11B are coupled via the resistive layer 18, and the gate wiring 11B and the gate wiring 11C are coupled via the resistive layer 19.

Hereinbelow, features of the configuration of the above semiconductor device 10 are described in comparison to the related-art configuration. In the related-art trench gate MOSFET, the end portions of the trench gate electrodes 12A to 12F are coupled to one another via a common gate wiring 11. To the contrary, in the semiconductor device 10 according to this embodiment, the gate wiring 11 is divided into a plurality of pieces and adjacent gate wirings are coupled via the resistive layer 18 or 19. This can achieve the configuration of the equivalent circuit shown in Fig. 1 in which a plurality of trench gate electrodes 12A to 12F are divided into a plurality of groups respectively corresponding to a plurality of gate electrode portions GE and adjacent gate electrode portions GE are coupled by the resistive layer corresponding to the resistive element R. It should be noted that, with the structure of the vertical MOSFET, because the drain current flows through a channel region near each of the trench gate electrodes 12A to 12F, the drain current is inevitably divided into a plurality of current components respectively corresponding to a plurality of gate electrode portions GE. Other features in Figs. 4 to 6 are the same as those of the related-art configuration. Thus, the semiconductor device 10 according to this embodiment can be manufactured almost without changing the related-art manufacturing process.

### [Method of Manufacturing Semiconductor Device]

Hereinbelow, description is given taking an example of a method of manufacturing the semiconductor device 10 according to this embodiment.

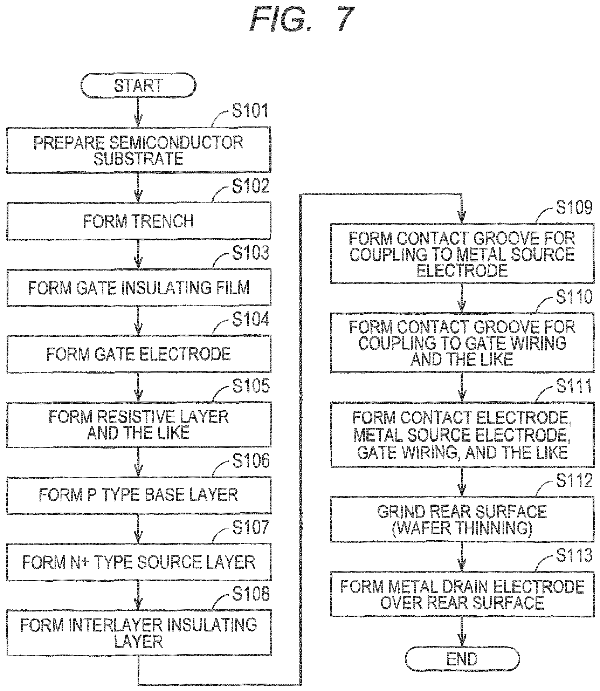

Fig. 7 is a flowchart showing an example of a method of manufacturing the semiconductor device shown in Figs. 4 to 6. With reference to Figs. 4 to 6, an N type silicon semiconductor substrate SUB made of silicon single crystal is prepared first (Step S101 in Fig. 7).

The trench 30 is formed from the first main surface 33 side of the N type semiconductor substrate SUB (Step S102) . Specifically, a hard mask film for forming a trench is formed over the first main surface 33 using a lithography process, and an anisotropic dry etching is performed using the hard mask film to form the trench 30. After forming the trench 30, the hard mask film is removed by wet etching.

The gate insulating film 23 is formed almost all over the first main surface 33 of the N type semiconductor substrate SUB and the internal surface of the trench 30 by, for example, thermal oxidation (Step S103).

A doped polysilicon (Doped Poly-Silicon) film doped with phosphorus, for example, is formed almost all over the gate insulating film 23 so as to fill the trench 30 by the CVD (Chemical Vapor Deposition) or the like. The unnecessary doped polysilicon film except the gate electrodes 12A to 12F and the peripheral gate electrode 12 is removed by, for example, wet etching. In this manner, the gate electrodes 12A to 12F and the peripheral gate electrode 12 are formed (Step S104).

A polysilicon film is formed almost all over the first main surface 33 side of the semiconductor substrate SUB. A portion of the formed polysilicon film to be the resistive layers 18 and 19 is made resistive by ion-implanting impurities. The remaining portion of the polysilicon film other than the resistive layers 18 and 19 is removed by, for example, wet etching. The resistive layers 18 and 19 are formed (Step S105) .

P type impurities are ion-implanted using a resist film formed by the lithography process as a mask. The P type base layer 25 is formed by thermal diffusion (Step S106) . The unnecessary resist film is then removed by ashing or the like.

N type impurities are ion-implanted using the resist film formed by the lithography process as a mask. In this manner, the N+ type source layer 24 is formed in an upper region of the P type base layer 25 (Step S107). The unnecessary resist film is removed by ashing or the like.

The interlayer insulating layer 21 is formed almost all over the first main surface 33 side of the N- type semiconductor substrate SUB by the CVD, coating, or the like (Step S108) . As a material of the interlayer insulating layer 21, for example, a PSG (Phosphosilicate Glass) film, a BPSG (Borophosphosilicate Glass) film, an NSG (Non-doped Silicate Glass) film, an SOG (Spin-On-Glass) film, or a composite film thereof can be used.

A contact groove 31 for coupling to the metal source electrode 16 is formed between adjacent trenches 30 and outside the outermost trench 30 (Step S109). Specifically, the contact groove 31 is formed by the anisotropic dry etching or the like using the resist film formed by the lithography process, for example. The unnecessary resist film is removed by ashing or the like.

A contact hole for coupling to the gate wirings 11A to 11C is formed in the end portion of the gate electrodes 12A to 12F and a contact groove for coupling to the gate pad 11P is formed above the peripheral gate electrode 12 (Step S110) . Specifically, the contact hole is formed by the anisotropic dry etching or the like using the resist film formed by the lithography process, for example. The unnecessary resist film is removed by ashing or the like.

An aluminum-based metal thick film is formed almost all over the first main surface 33 side of the N type semiconductor substrate SUB by sputtering film formation or the like. By subsequently etching the metal thick film using the lithography process and etching, the gate pad 11P, the gate wiring 11A to 11C, the metal source electrode 16, and the contact electrode17, 15A to 15F, 14 are formed (Step S111).

Thickness of the substrate is adjusted by grinding the second main surface 34 (rear surface) of the N type semiconductor substrate SUB (Step S112) .

The metal drain electrode 29 is then formed almost all over the second main surface 34 of the N type semiconductor substrate SUB by the sputtering film formation or the like (Step S113) . The semiconductor device 10 having the configuration shown in Figs. 4 to 6 is completed by the process described above.

### [Effect]

As described above, the semiconductor device 10 according to this embodiment is configured based on a MOSFET, and has a configuration in which a plurality of MOSFETs are equivalently coupled in parallel by dividing the gate electrode portion GE into a plurality of pieces. Furthermore, the semiconductor device 10 according to this embodiment is characterized in that the gate resistance values of the MOSFETs coupled in parallel are different. Because this can offset the timing at which the MOSFET breaks at the time of turn-off, it is possible to increase the breaking speed of each MOSFET (specifically increase the current change rate di/dt) within a range of acceptable surge voltage. As a result, the breaking time of all the MOSFETs can be reduced.

Moreover, because the external coupling terminal is configured by three terminals including the gate terminal GT, the source terminal ST, and the drain terminal DT as with the related-art MOSFET, it is possible to achieve an effect of suppressing the surge voltage and preventing reduction of the breaking speed using an existing gate drive circuit as it is. Suppression of the surge voltage eliminates necessity of excessively ensuring a voltage margin of a component that configures the system, thereby reducing the component cost.

### [Variation]

Although the first embodiment was described taking an example of dividing the gate electrode portion GE into three, the number into which the gate electrode portion GE is divided may not necessarily be three.

In general, the semiconductor device includes N (N is an integer equal to or larger than 2) gate electrode portions GE and N-1 resistive elements R. In this case, the semiconductor device has a configuration in which N transistors including N gate electrode portions GE, respectively, are equivalently coupled in parallel. The first gate electrode portion GE is coupled to the gate terminal GT for receiving the gate control signal without any one of the N-1 resistive elements R. The i+1th (i is an integer equal to or larger than 1 and equal to or smaller than N-1) gate electrode portion GE is coupled to the ith gate electrode portion GE via the ith resistive element R. In this manner, the resistance value of the transmission path of the gate control signal from the gate terminal GT can be varied with respect to each gate electrode portion GE.

Moreover, description is given about the above general configuration in which each gate electrode portion GE is configured by a plurality of electrode elements (for example, trench gate electrodes) extending in the first direction and arranged in the second direction. In this case, if N gate electrode portions GE are arranged in numerical order in the second direction, the ith (i is an integer equal to or larger than 1 and equal to or smaller than N-1) resistive element is coupled between the last electrode element in the arrangement order in the second direction among a plurality of electrode elements included in the ith gate electrode and the first electrode element in the arrangement order in the second direction among a plurality of electrode elements included in the i+1th gate electrode.

Although the first embodiment was described taking an example in which each of electrode elements configuring each gate electrode portion GE is configured by the trench gate, each electrode element may be configured as a planar gate electrode. Furthermore, although the first embodiment was described taking an example of the vertical MOSGET, the technique described above can also be applied to a lateral MOSFET.

Although the first embodiment was described taking an example in which the gate resistance value varies with respect to each divided gate electrode portion GE, more generally, it suffices that a product of values of the capacitance and the gate resistance of each gate electrode portion GE may be different from one another. For example, the capacitance can be varied with respect to each gate electrode portion GE by changing the gate width (specifically, the number of trench gates included).

### Second Embodiment

A second embodiment is described taking an example of configuring a semiconductor device based on an IGBT (Insulated Gate Bipolar Transistor) . The technique described in the first embodiment can be applied not only to the IGBT described below but also to various types of transistors.

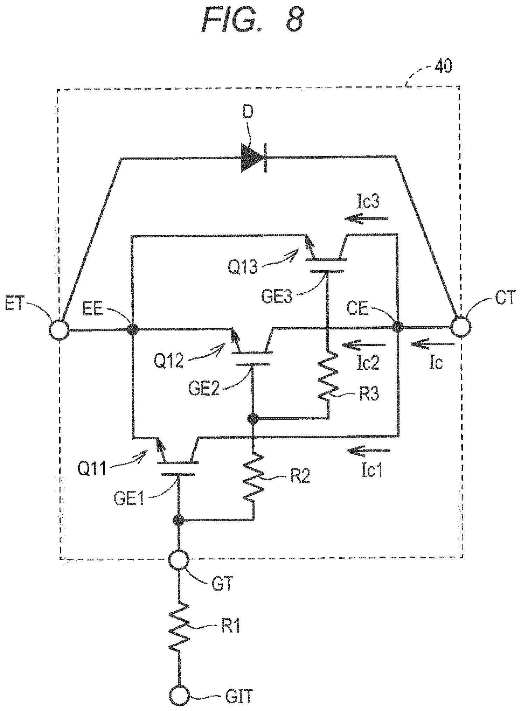

Fig. 8 is an equivalent circuit showing the configuration of the semiconductor device according to the second embodiment. With reference to Fig. 8, a semiconductor device 40 is configured based on the IGBT, and includes a collector electrode CE as a first main electrode, an emitter electrode EE as a second main electrode, gate electrode portions GE1, GE2, GE3 as a plurality of control electrodes, resistive elements R2, R3, and a diode D.

In the case of Fig. 8, as compared to Fig. 1, the collector electrode CE is provided instead of the drain electrode DE and the emitter electrode EE is provided instead of the source electrode SE. Equivalently, the semiconductor device 40 can be regarded as a set of three IGBTs Q11, Q12, Q13 coupled in parallel. In this case, a collector current Ic as a main current is divided into a plurality of collector current components Ic1, Ic2, Ic3 corresponding to a plurality of gate electrode portions GE1, GE2, GE3, respectively.

The semiconductor device 40 includes a collector terminal CT, an emitter terminal ET, and a gate terminal GT to be coupled to the outside. The collector terminal CT is coupled to the collector electrode CE, and the emitter terminal ET is coupled to the emitter electrode EE. The gate terminal GT is coupled directly to the gate electrode portion GE1 and indirectly to the gate electrode portion GE2 via the resistive element R2. Furthermore, the gate electrode portion GE2 is coupled to the gate electrode portion GE3 via the resistive element R3.

Because the IGBT does not include a parasitic diode in principle, the diode D for current commutation is coupled between the collector terminal CT and the emitter terminal ET in the reverse-bias direction, namely an anode of the diode D is coupled to the emitter terminal ET. Although Fig. 8 shows the case in which the diode D is incorporated in the semiconductor device 40, the diode D may also be mounted outside the semiconductor device 40.

Because other features in Fig. 8 are the same as those in Fig. 1, like or corresponding components are denoted by like numerals and the explanation thereof is not repeated. A specific structure of the semiconductor device 40 is described below.

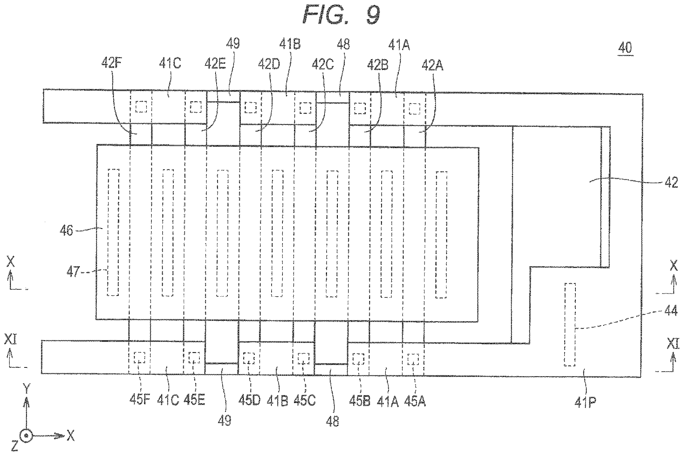

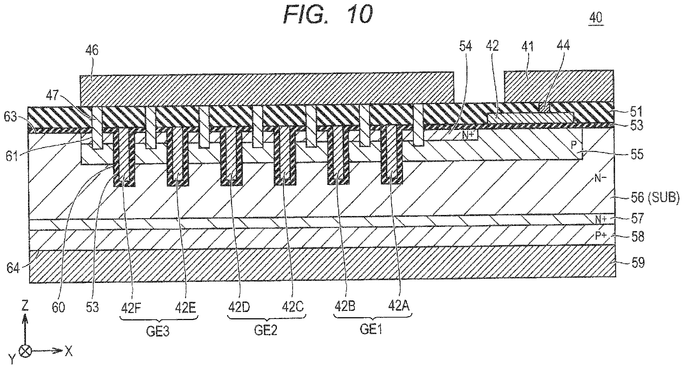

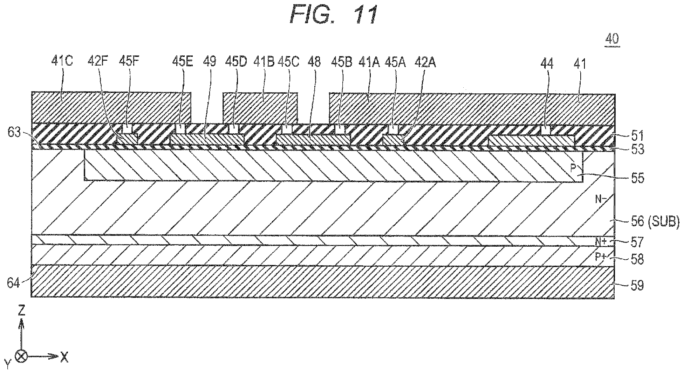

Fig. 9 is a plan view showing an example of a structure of the semiconductor device corresponding to the equivalent circuit shown in Fig. 8. Fig. 10 is a sectional view taken along a section line X-X shown in Fig. 9. Fig. 11 is a sectional view taken along a section line XI-XI shown in Fig. 9. In the following description, directions parallel to the N- type semiconductor substrate SUB are regarded as an X direction and a Y direction, and a direction perpendicular to the N- type semiconductor substrate SUB is regarded as a Z direction. It should be noted that an interlayer insulating layer 51 and a gate insulating film 53 are not shown in Fig. 9. It is also noted that the dimensions of portions shown in Figs. 9 to 11 are not proportional to the actual dimensions for better understanding.

With reference to Figs. 9 to 11, the semiconductor device 40 is formed mainly based on the N- type semiconductor substrate SUB used as an N- type drift layer 56. In the following description, a surface of the N- type semiconductor substrate SUB on the side of the +Z direction is referred to as a first main surface 63 or a front surface (front face), and a surface on the side of the -Z direction is referred to as a second main surface 64 or a rear surface.

As shown in Fig. 10, the semiconductor device 40 includes an N+ type emitter layer 54 and a P type base layer 55 from the closer side to the first main surface 63 of the N- type semiconductor substrate SUB, and includes a P+ type collector layer 58 and an N+ type field stop layer 57 from the closer side to the second main surface 64, as impurity layers. A structural difference as compared to the MOSFET described with reference to Figs. 4 to 6 is that the P+ type collector layer 58 is further formed over the outermost face of the second main surface 64 of the N- type semiconductor substrate SUB as the impurity layer.

It should be noted that the periphery of the P type base layer 55 is not coated with the N+ type emitter layer 54. Formed over the periphery of this P type base layer 55 is a peripheral gate electrode 42 via the gate insulating film 53.

The semiconductor device 40 is formed with a plurality of trenches (grooves) 60 starting from the first main surface 63 through the N+ type emitter layer 54 and the P type base layer 55 to the internal of the N- type drift layer 56. As the N- type semiconductor substrate SUB is seen from the above, the trenches 60 extend in the Y direction and are arrayed along the X direction. The semiconductor device 40 includes the gate insulating film 53 formed over the internal surface of each trench 60 and trench gate electrodes 42A to 42F that are embedded electrodes filled in each trench 60 via the gate insulating film 53.

The trench gate electrodes 42A and 42B are electrically coupled to each other via a gate wiring 41A to be described later, and correspond to the gate electrode portion GE1 shown in Fig. 8. Similarly, the trench gate electrodes 42C and 42D are electrically coupled to each other via a gate wiring 41B to be described later, and correspond to the gate electrode portion GE2 shown in Fig. 8. The trench gate electrodes 42E and 42F are electrically coupled to each other via a gate wiring 41C to be described later, and correspond to the gate electrode portion GE shown in Fig. 8.

In this manner, each gate electrode portion GE is configured by a plurality of electrode elements electrically coupled to one another. Each electrode element corresponds to each of the trench gate electrodes 42A to 42F. A resistance value between the electrode elements is smaller than that of any one of the resistive element R2, R3 shown in Fig. 8.

The semiconductor device 40 further includes the aforementioned peripheral gate electrode 42, the interlayer insulating layer 51, and resistive layers 48 and 49.

The peripheral gate electrode 42 and the resistive layers 48 and 49 are formed over the gate insulating film 53. The resistive layer 48 is formed by, for example, polysilicon so as to couple an end portion of the trench gate electrode 42B and an end portion of the trench gate electrode 42C. The resistive layer 49 is formed by, for example, polysilicon so as to couple an end portion of the trench gate electrode 42D and an end portion of the trench gate electrode 42E. The resistive layer 48 corresponds to the resistive element R2 shown in Fig. 8, and the resistive layer 49 corresponds to the resistive element R3 shown in Fig. 8.

The interlayer insulating layer 51 is formed over the gate insulating film 53 so as to cover the trench gate electrode 42A to 42F, the resistive layers 48 and 49, and the peripheral gate electrode 42.

The semiconductor device 40 further includes a metal emitter electrode 46, a metal collector electrode 59, gate wirings 41A, 41B, 41C, and a gate pad 41P. The gate wiring 41A and the gate pad 41P are formed integrally.

The metal emitter electrode 46 is formed over the interlayer insulating layer 51, and coupled to the N+ type emitter layer 54 and the P type base layer 55 via a plurality of contact electrodes 47. These contact electrodes 47 are arranged between adjacent trenches 60 and outside the trench 60 arranged outermost. Each contact electrode 47 penetrates the interlayer insulating layer 51, the gate insulating film 53, and the N+ type emitter layer 54 to reach the internal of the P type base layer 55. The metal emitter electrode 46 corresponds to the emitter electrode EE shown in Fig. 8.

The metal collector electrode 59 is formed abutting the P+ type collector layer 58 on the rear surface side of the N- type semiconductor substrate SUB. The metal collector electrode 59 corresponds to the collector electrode CE shown in Fig. 8.

The gate wiring 41A extends generally in the X direction and is coupled via end portions of the contact electrodes 45A and 45B, respectively. The gate wiring 41A is formed integrally with the gate pad 41P. The gate pad 41P is coupled to the gate electrode 42 via a contact electrode 44.

The gate wiring 41B extends in the X direction and is coupled via end portions of the gate electrodes 42C and 42D and contact electrodes 45C and 45D, respectively. The gate wiring 41C extends in the X direction and is coupled via end portions of the gate electrodes 42E and 42F, and contact electrodes 45E and 45F, respectively. Thus, the gate wiring 41A and the gate wiring 41B are coupled via the resistive layer 48, and the gate wiring 41B and the gate wiring 41C are coupled via the resistive layer 49.

As with the MOSFET in the first embodiment, the configuration of the semiconductor device 40 is the same as the trench gate type IGBT of the related art except for the resistive layers 48 and 49. Thus, the semiconductor device 40 according to this embodiment can be manufactured almost without changing the related-art manufacturing process.

Although the above embodiment was described taking an example in which each of the electrode elements configuring each gate electrode portion GE is configured by the trench gate, each electrode element may be configured as a planar gate electrode.

As described above, the semiconductor device 40 according to this embodiment is configured based on the IGBT, and has a configuration in which a plurality of IGBTs are equivalently arranged in parallel by dividing the gate electrode portion GE into a plurality of pieces. Furthermore, the semiconductor device 40 according to this embodiment is characterized in that the gate resistance values of the IGBTs coupled in parallel are different. Because this can offset the timing at which the IGBT breaks at the time of turn-off, it is possible to increase the breaking speed of each IGBT (specifically increase the current change rate di/dt) within a range of acceptable surge voltage. As a result, the breaking time of all the IGBTs configuring the semiconductor device 40 can be reduced. Moreover, because the external coupling terminal is configured by three terminals including the gate terminal GT, emitter terminal ET, and the collector terminal CT as with the related-art IGBT, it is possible to achieve an effect of suppressing the surge voltage and preventing reduction of the breaking speed using an existing gate drive circuit as it is.

Although the second embodiment was described taking an example in which the gate resistance value varies with respect to each divided gate electrode portion GE, more generally, it suffices that a product of values of the capacitance and the gate resistance of each gate electrode portion GE may be different from one another. For example, the capacitance can be varied with respect to each gate electrode portion GE by changing the gate width (specifically, the number of trench gates included).

### Third Embodiment

A third embodiment is described taking an example of using the semiconductor device 10 according to the first embodiment as a bidirectional switch. The semiconductor device 40 according to the second embodiment can be used similarly as the bidirectional switch according to this embodiment.

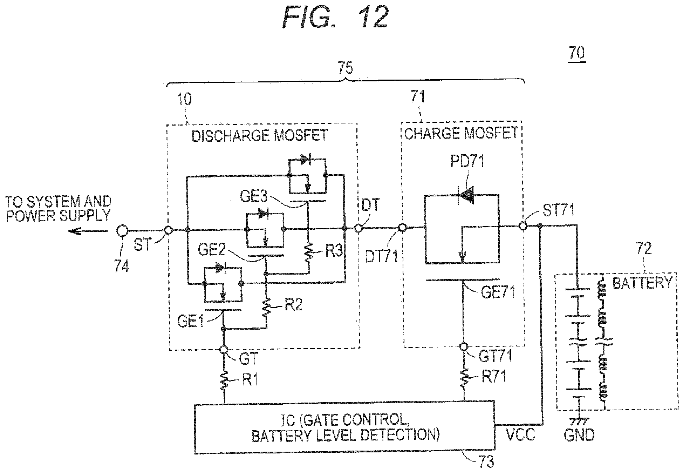

Fig. 12 is a circuit diagram showing an example of a bidirectional switch used in a rechargeable battery pack. With reference to Fig. 12, a rechargeable battery pack 70 includes a bidirectional switch 75, a battery (rechargeable battery) 72, and a control IC (Integrated Circuit) 73. The control IC 73 controls on-off of the bidirectional switch 75 and monitors a level of the battery 72.

The bidirectional switch 75 includes the semiconductor device 10 being a discharge MOSFET and a semiconductor device 71 being a charge MOSFET coupled to the semiconductor device 10 in anti-series.

The semiconductor device 10 has the same configuration as described in the first embodiment. The gate terminal GT of the semiconductor device 10 is coupled to the control IC 73 via the resistive element R1. The semiconductor device 71 has the same structure as the related-art MOSFET. The gate electrode portion GE71 of the semiconductor device 71 is coupled directly to the gate terminal GT71, and the gate terminal GT71 is coupled to the control IC 73 via the resistive element R71.

In the semiconductor device 10 used for discharge, the drain terminal DT is coupled to the battery 72 side and the source terminal ST is coupled to a terminal 74 on the system side. In the semiconductor device 71 used for charge, a drain terminal DT71 is coupled to the terminal 74 side and a source terminal ST71 is coupled to the battery 72. The semiconductor device 10 and the semiconductor device 71 may be coupled in the reverse order.

When charging, according to control by the control IC 73, the MOSFET configuring the semiconductor device 10 falls into an off state and the MOSFET configuring the semiconductor device 71 falls into an on state. This allows the charge current to flow from a power supply on the system side to the battery 72 through the parasitic diode in the semiconductor device 10 and the MOSFET in the semiconductor device 71.

On the other hand, when discharging, according to control by the control IC 73, the MOSFET configuring the semiconductor device 10 falls into the on state and the MOSFET configuring the semiconductor device 71 falls into the off state. This allows the discharge current to flow from the battery 72 to the system side through the MOSFET in the semiconductor device 10 and a parasitic diode PD71 in the semiconductor device 71.

When an overcurrent is detected due to a system failure or the like, the MOSFET configuring the semiconductor device 10 needs to be quickly turned off. In this case, because a parasitic inductance is present in the circuit of the rechargeable battery pack 70 and in the cell of the battery 72, surge voltage is caused by the current breaking due to turn-off of the MOSFET.

Now, as described in the first embodiment, the semiconductor device 10 has a configuration in which a plurality of MOSFETs are equivalently coupled in parallel by dividing the gate electrode portion GE into a plurality of pieces. Furthermore, the semiconductor device 10 is characterized in that the gate resistance values of the MOSFETs coupled in parallel are different. Because this can offset the timing at which the MOSFET breaks at the time of turn-off, it is possible to reduce the breaking time while keeping the surge voltage within an acceptable range.

### Fourth Embodiment

A fourth embodiment is described taking an example of applying the semiconductor device 10 according to the first embodiment to a switching element of an inverter device. The semiconductor device 10 according to the first embodiment and the semiconductor device 40 according to the second embodiment can be used as a switching element of not only the inverter device but also of various power converters.

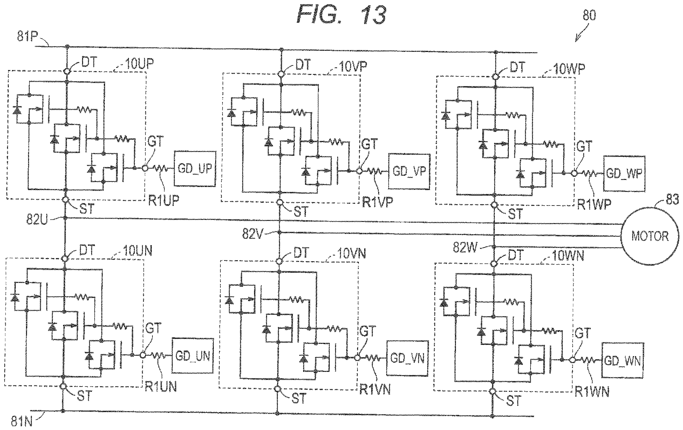

Fig. 13 is a circuit diagram showing a configuration of the inverter device. With reference to Fig. 13, an inverter device 80 includes semiconductor devices 10UP, 10UN, 10VP, 10VN, 10WP, 10WN, and gate drivers GD_UP, GD_UN, GD_VP, GD_VN, GD_WP, GD_WN respectively driving these semiconductor devices. It should be noted that the inverter device 80 may be configured as a power module in which the semiconductor devices are mounted in the same package.

The semiconductor device 10UP and the semiconductor device 10UN are coupled in series between a high-voltage side power line 81P and a low-voltage side power line 81N. A DC voltage is applied between the high-voltage side power line 81P and the low-voltage side power line 81N. Similarly, the semiconductor device 10VP and the semiconductor device 10VN are coupled in series between the high-voltage side power line 81P and the low-voltage side power line 81N. The semiconductor device 10WP and the semiconductor device 10WN are coupled in series between the high-voltage side power line 81P and the low-voltage side power line 81N. It should be noted that the drain terminal DT of each semiconductor device is coupled to the high-voltage side and the source terminals ST is coupled to the low-voltage side.

A U-phase AC voltage is supplied to a motor 83 from a coupling node 82U between the semiconductor device 10UP and the semiconductor device 10UN. A V-phase AC voltage is supplied to the motor 83 from a coupling node 82V between the semiconductor device 10VP and the semiconductor device 10VN. A W-phase is supplied to the motor 83 from a coupling node 82W between the semiconductor device 10WP and the semiconductor device 10WN.

In the configuration shown in Fig. 13, the surge voltage is caused by the inductance present in a stator winding of the motor 83, the wiring of the inverter device 80, and the like when switching each semiconductor device. The inverter device 80 according to this embodiment has a configuration in which, as described in the first embodiment, equivalently a plurality of MOSFETs are coupled in parallel by dividing the gate electrode portion GE into a plurality of pieces. Furthermore, each semiconductor device is characterized in that the gate resistance values of the MOSFETs coupled in parallel are different. Because this can offset the timing at which the MOSFETs configuring the semiconductor devices are switched, fast switching is made possible while keeping the surge voltage within an acceptable range.

Although the invention made by the inventors was specifically described based on the embodiments, it is needless to say that the invention is not limited to the above embodiments and can be modified in various ways without departing from the spirit of the invention.

## Claims

1. A semiconductor device comprising:
a first main electrode;
a second main electrode;
a plurality of control electrode portions each of which controls current flowing between the first main electrode and the second main electrode according to a control signal; and
a control terminal that receives the control signal from the outside,
wherein a product of values of capacitance of the control electrode portion and resistance of a transmission path of the control signal varies with respect to each control electrode portion.

2. The semiconductor device according to claim 1,
wherein the resistance value of the transmission path of the control signal from the control terminal varies with respect to each control electrode portion.

3. The semiconductor device according to claim 1 or 2,
wherein the semiconductor device comprises N (N is an integer equal to or larger than 2) control electrode portions as the control electrode portions,
wherein the semiconductor device further comprises N-1 resistive elements,
wherein the first control electrode portion is coupled to the control terminal without any one of the N-1 resistive elements, and
wherein the i+1th (i is an integer equal to or larger than 1 and equal to or smaller than N-1) control electrode portion is coupled to the ith control electrode portion via the ith resistive element.

4. The semiconductor device according to one of claims 1 to 3,
wherein the first main electrode is provided over a first main surface of a substrate, and
wherein the second main electrode is provided over a second main surface of the substrate opposite from the first main surface.

5. The semiconductor device according to one of claims 1 to 4,
wherein each of the control electrode portions is provided over the first main surface side of the substrate and includes a plurality of electrode elements electrically coupled to one another,
wherein each of the electrode elements extends in a first direction along the first main surface, and the electrode elements are generally arranged in parallel with a second direction along the first main surface, and
a resistance value between the electrode elements is smaller than a resistance value of any one of the N-1 resistive elements.

6. The semiconductor device according to claim 5, wherein each of the electrode elements is a trench gate electrode.

7. The semiconductor device according to one of claims 1 to 5,
wherein the ith (i is an integer equal to or larger than 1 and equal to or smaller than N-1) resistive element is coupled between the last electrode element in the arrangement order in the second direction among the electrode elements included in the ith control electrode portion and the first electrode element in the arrangement order in the second direction among the electrode elements included in the i+1th control electrode portion.

8. The semiconductor device according to one of claims 1 to 7,
wherein the semiconductor device is configured based on a MOSFET (Metal Oxide Semiconductor Field Effect Transistor) or an IGBT (Insulated Gate Bipolar Transistor).

9. A semiconductor device comprising:
a substrate;
a first main electrode provided over a first main surface of the substrate;
a second main electrode provided over a second main surface of the substrate opposite from the first main surface;
a plurality of control electrode portions each of which controls current flowing between the first main electrode and the second main electrode according to a control signal; and
a control terminal that receives the control signal from the outside,
wherein a product of values of capacitance of the control electrode portion and resistance of a transmission path of the control signal varies with respect to each control electrode portion.

10. A power converter using a semiconductor device according to one of claims 1 to 8 as a switching element.
